# FASCICULE DE BREVET EUROPEEN

(11) **EP 1 398 900 B1**
(45) Date de publication et mention de la délivrance du brevet: **12.04.2006**
(21) Numéro de dépôt: 03300116.5
(22) Date de dépôt: 12.09.2003
(51) Int. Cl.: H04L 7/033, H03K 5/13, H03K 5/00

(54) **Transformation d'un signal périodique en un signal de fréquence ajustable**
Umwandlung von einem periodischen Signal in ein Signal mit einstellbarer Frequenz
Convertion of a periodic signal into a signal with adjustable frequency

(30) Priorité: 13.09.2002 FR 0211418
(43) Date de publication de la demande: 17.03.2004
(73) Titulaire: ST MICROELECTRONICS S.A., 92120 Montrouge (FR)
(72) Inventeur: Marbot, M. Roland, 38360 Sassenage (FR); Hellard, M. Franck, 38000 Grenoble (FR)
(74) Mandataire: de Beaumont, Michel

(56) Documents cités:
- EP-A- 0 901 227
- WO-A-94/26032

## Description

La présente invention concerne les dispositifs de transformation d'un signal de référence périodique en un signal de fréquence ajustable.

De tels dispositifs sont par exemple utilisés dans des circuits de transmission de données en série entre un ordinateur et des disques durs.

Les données à émettre arrivent du coeur de l'ordinateur en parallèle sur chaque circuit de transmission généralement par l'intermédiaire d'un bus dit PCI (de l'anglais Peripheral Communication Interface). En sortie de chaque circuit de transmission, un sérialiseur émet des données série sur un câble de liaison tel qu'un câble coaxial ou une liaison à fibres optiques.

Afin de limiter les émissions électromagnétiques lors de la transmission de données sur les câbles de liaison, les données série peuvent être émises à fréquence variable. De façon classique, la fréquence d'émission varie entre une fréquence de référence, par exemple 1 GHz, et une fréquence plus lente d'au plus 5%, par exemple 995 MHz. La modulation en fréquence est périodique, la fréquence de modulation étant couramment comprise entre 30 et 33 kHz.

A partir d'un signal d'horloge de référence, variant à la fréquence de référence, un dispositif de transformation fournit un signal d'horloge ayant une fréquence de sérialisation commandant le sérialiseur.

Certains dispositifs de transformation de fréquence connus sont réalisés avec un circuit de boucle à verrouillage de phase, ou PLL, de l'anglais "Phase Locked Loop".

Un inconvénient de tels dispositifs est que leur surface peut être très importante.

De plus, ces dispositifs comprennent de façon générale des circuits analogiques : un oscillateur commandé en tension et un filtre passe-bas. Ces circuits analogiques doivent être adaptés à chaque technologie de circuits intégrés, et le fonctionnement de tels circuits dans toutes les configurations possibles notamment de température, de procédé de fabrication, et de tension d'alimentation, pose plus de problèmes que celui de circuits entièrement numériques.

La demande de brevet internationale WO 94/26032 de Ericsson du 10 novembre 1994 décrit un système pour mettre un signal "local" émis par un oscillateur local de fréquence stable en phase avec un signal de référence de fréquence variable. Le système comprend deux lignes de retard actives alternativement qui reçoivent le signal local et fournissent des signaux retardés à un circuit de sélection.

Un objet de la présente invention est de prévoir un dispositif de transformation de fréquence peu volumineux.

Un autre objet de la présente invention est de prévoir un tel dispositif entièrement numérique.

Un autre objet de la présente invention est de prévoir un tel dispositif de structure simple.

Pour atteindre ces objets, la présente invention prévoit un dispositif de transformation d'un signal d'entrée périodique en un signal de sortie de fréquence distincte, comprenant deux moyens de retard réglables recevant le signal d'entrée, la différence entre les retards maximal et minimal de chaque moyen de retard étant supérieure à une période du signal d'entrée, un multiplexeur sélectionnant le signal de sortie de l'un ou l'autre des moyens de retard, des moyens de commande pour, selon que la fréquence du signal de sortie doit être inférieure ou supérieure à la fréquence du signal d'entrée, faire croître ou décroître au rythme du signal d'entrée, ou à un multiple de ce rythme, le retard du moyen de retard sélectionné, et commander un retard minimal ou maximal pour le moyen de retard non sélectionné et un comparateur de phase adapté à changer la sélection du multiplexeur quand les transitions des signaux sortants des moyens de retard correspondant à une même transition du signal d'entrée sont décalées d'une durée supérieure ou égale à une période du signal d'entrée.

Selon un mode de réalisation d'un tel dispositif de transformation, les moyens de commande comprennent des moyens pour fixer le rythme d'augmentation ou de diminution du retard du moyen de retard.

Selon un mode de réalisation d'un tel dispositif de transformation, le retard du moyen de retard est susceptible de varier par incréments ou décréments et les moyens de commande comprennent des moyens pour fixer la valeur d'incrément ou de décrément.

Selon un mode de réalisation d'un tel dispositif de transformation, chaque moyen de retard comprend plusieurs éléments de retard en série, la sortie de chaque élément de retard étant reliée à la sortie du moyen de retard par l'intermédiaire d'un interrupteur, l'entrée du premier élément de retard étant reliée à l'entrée du moyen de retard.

Selon un mode de réalisation d'un tel dispositif de transformation, le comparateur de phase comprend deux portes NON-ET à deux entrées, la sortie d'une porte NON-ET étant reliée à une première entrée de l'autre porte NON-ET, chaque porte NON-ET recevant sur sa seconde entrée un des signaux sortants desdits moyens de retard, un de ces signaux étant transmis à l'entrée de commande d'une première bascule par l'intermédiaire d'un circuit non inverseur présentant un retard, la sortie d'une des porte NON-ET étant reliée à l'entrée de données de la première bascule, la sortie de la première bascule commandant une seconde bascule dont la sortie est reliée à son entrée par l'intermédiaire d'un inverseur, la sortie de la seconde bascule commandant le multiplexeur du dispositif de transformation.

Selon un mode de réalisation d'un tel dispositif de transformation, le retard d'un des moyens de retard augmente ou diminue seulement pendant un ou plusieurs cycles d'un ensemble de cycles du signal d'entrée, le nombre d'augmentations ou de diminutions du retard sur un ensemble de cycles étant d'autant plus élevé que la fréquence du signal de sortie est éloignée de la fréquence du signal d'entrée.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1 est un schéma d'un dispositif de transformation de fréquence selon la présente invention ;
la figure 2 est un diagramme illustrant la forme des signaux en divers points du dispositif de la figure 1 ;
la figure 3 est un schéma d'un mode de réalisation d'un moyen de retard du dispositif de la présente invention ;
la figure 4 est un schéma d'un mode de réalisation du comparateur de phase du dispositif de la présente invention ; et
la figure 5 est un diagramme illustrant les signaux en divers points du dispositif de la figure 1 selon _une variante d'utilisation du dispositif.

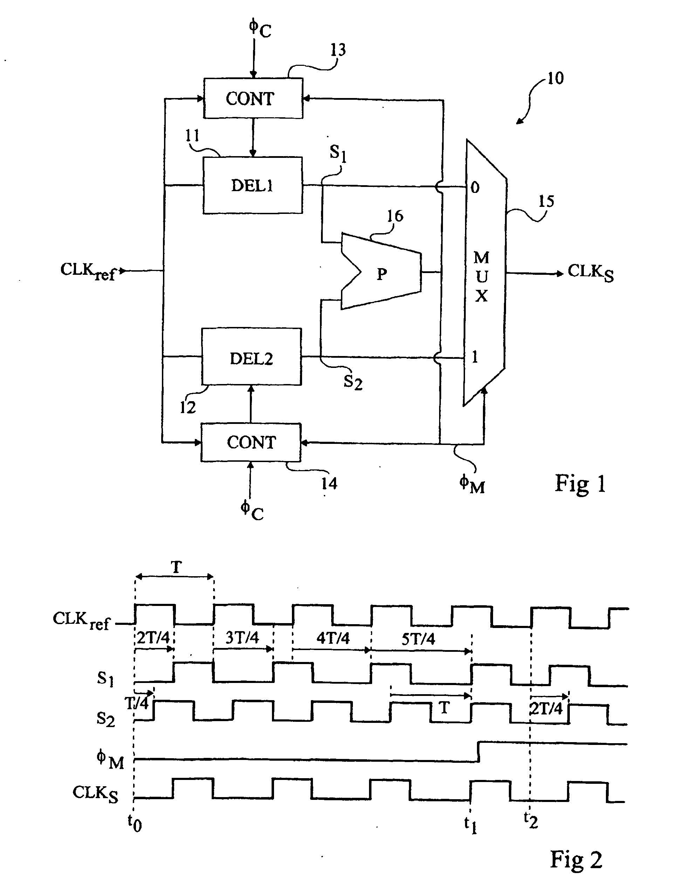

La figure 1 est un schéma d'un dispositif de transformation 10 d'un signal d'horloge de référence CLK_{ref} de fréquence f_{ref} et de période T, en un signal d'horloge CLKₛ de fréquence fₛ différente de f_{ref}. Le dispositif 10 comprend deux moyens de retard réglables 11 (DEL1) et 12 (DEL2) qui reçoivent le signal CLK_{ref} et fournissent respectivement des signaux S₁ et S₂. Le signal S₁ est retardé par rapport à CLK_{ref} d'un retard DEL₁ réglable sur commande d'un circuit de commande (CONT) 13. Le signal S₂ est retardé par rapport à CLK_{ref} d'un retard DEL₂ réglable sur commande d'un circuit de commande (CONT) 14. Un multiplexeur (MUX) 15 reçoit le signal S₁ sur son entrée "0" et le signal S₂ sur son entrée "1". Un signal de sélection Φ_{M} commande le multiplexeur 15 qui fournit le signal d'horloge CLKₛ. Un comparateur de phase (P) 16 reçoit les signaux S₁ et S₂ et fournit le signal de sélection Φ_{M}. Les circuits de commande 13 et 14 sont identiques et reçoivent le signal d'horloge CLK_{ref}, le signal de sélection Φ_{M} ainsi qu'un signal de commande Φ_{C} indiquant la fréquence souhaitée.

La figure 2 est un diagramme des signaux CLK_{ref}, S₁, S₂, Φ_{M} et CLKₛ du dispositif de la figure 1, dans le cas où la fréquence fₛ recherchée est inférieure à la fréquence de référence f_{ref}. Le signal d'horloge de référence CLK_{ref} est périodique, avec dans cet exemple un rapport cyclique de 50%. Six périodes complètes de CLK_{ref} sont représentées en figure 2. Initialement, à un instant t₀, le signal de sélection Φ_{M} est au niveau "0" et le signal S₁ est sélectionné. Le retard DEL2 du moyen de retard 12 est minimal et égal à T/4. Le retard DEL1 du moyen de retard 11 augmente progressivement de T/4, à la fréquence f_{ref}. Les premiers fronts montants représentés des signaux S₁ et CLK_{ref} sont décalés d'une demi-période de référence (2T/4). Les 2^{ièmes} fronts montants des signaux S₁ et CLK_{ref} sont décalés de 3T/4. Les 3^{ièmes} fronts montants des signaux S₁ et CLK_{ref} sont décalés de T. Les 4^{ièmes} fronts montants des signaux S₁ et CLK_{ref} sont décalés de 5T/4.

Pendant toute cette durée, le signal S₂ est décalé de T/4 par rapport au signal CLK_{ref}. Le multiplexeur 15 fournit le signal S₁ jusqu'au quatrième front montant de S₁. A cet instant t₁, les 4^{ièmes} fronts montants des signaux S₁ et S₂ correspondant au décalage du quatrième front montant du signal CLK_{ref} sont décalés d'une période de référence T. Le comparateur de phase 16 fait alors commuter le signal de sélection Φ_{M} de 0 à 1 et le multiplexeur sélectionne le signal S₂. Lors du front montant suivant du signal CLK_{ref}, c'est-à-dire le sixième front montant représenté à un instant t₂, le retard DEL₂ du moyen de retard 12 est augmenté et les 6^{ièmes} fronts montants des signaux S₂ et CLK_{ref} sont décalés d'une demi-période de référence (2T/4), alors que le retard DEL1 reste constant et égal à T/4.

Le retard DEL2 augmente jusqu'à ce que les fronts montants des signaux S₁ et S₂ correspondant à un même front montant de CLK_{ref} soient décalés de la période T. A ce moment, la sélection s'inverse de nouveau.

La période du signal d'horloge CLKₛ est donc égale dans cet exemple à une période de référence plus un quart, soit 5T/4. La fréquence f_{S} est donc égale à 800 MHz quand la fréquence de référence vaut 1 GHz.

Le comparateur de phase 16 du dispositif de transformation 10 de la figure 1 a donc pour fonction de détecter le moment où les fronts montants des signaux S₁ et S₂ correspondant à un même front montant du signal d'horloge CLK_{ref} sont décalés d'une durée supérieure ou égale à une période de référence T. Le comparateur de phase 16 change alors le niveau du signal de sélection Φ_{M}. Le moyen de retard précédemment sélectionné prend un retard minimal (T/4). Le retard du moyen de retard nouvellement sélectionné augmente.

De façon générale, le comparateur de phase 16 peut détecter le moment où des transitions déterminées, un front montant ou descendant, des signaux S₁ et S₂ correspondant à une même transition du signal CLK_{ref}, sont décalés d'au moins une période T.

Les circuits de commande 13 et 14 peuvent être réalisés au moyen d'une machine d'états finis adaptée à faire croître le délai du moyen de retard sélectionné au rythme du signal CLK_{ref} et à positionner l'autre moyen de retard sur le retard minimal.

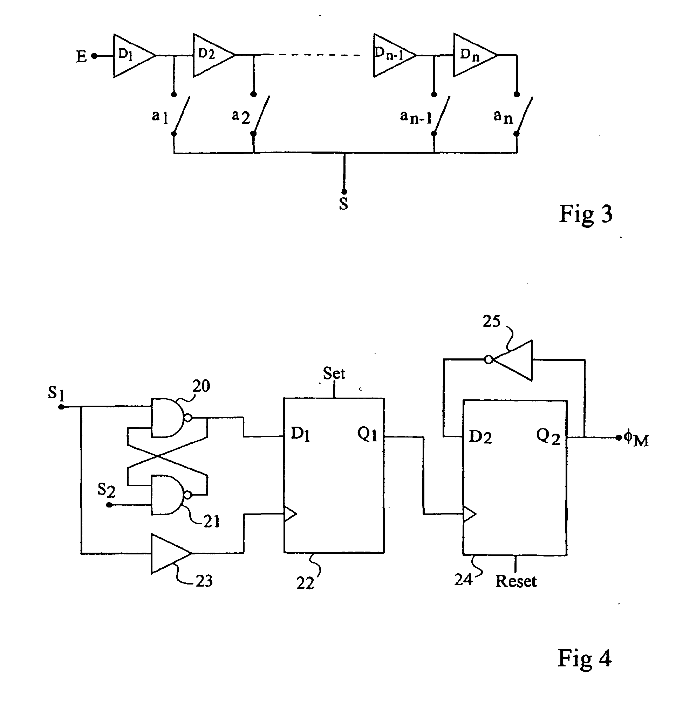

La figure 3 est un schéma d'un mode de réalisation des moyens de retard 11, 12 utilisés dans le dispositif de transformation 10 de la présente invention. Le moyen de retard comprend n éléments de retard D₁ à Dₙ en série, l'entrée E du moyen de retard étant reliée à l'entrée de l'élément de retard D₁. Un élément de retard peut par exemple être constitué de deux inverseurs en série. La sortie d'un élément de retard Dᵢ, i étant compris entre 1 et n, est reliée à la sortie S du moyen de retard par l'intermédiaire d'un interrupteur aᵢ. Le retard minimal entre E et S est obtenu en fermant l'interrupteur a₁ et en ouvrant tous les autres interrupteurs. Le retard entre E et S peut être progressivement augmenté en sélectionnant successivement les interrupteurs a₂, a₃ et ainsi de suite.

Le nombre d'éléments de retard doit être tel que la différence entre le retard maximal obtenu en sélectionnant l'interrupteur aₙ et le retard minimal obtenu en sélectionnant l'interrupteur a₁ soit supérieure à une période de référence T afin d'assurer un fonctionnement correct du dispositif 10. Il faut en effet que le moyen de retard sélectionné change au plus tard quand le retard du moyen de retard sélectionné est maximal.

Il existe d'autres moyens de retard plus perfectionnés tels que celui décrit dans la demande de brevet français 97 11 022 de la demanderesse.

La figure 4 est un schéma d'un mode de réalisation du comparateur de phase 16 du dispositif de transformation de la présente invention. Le comparateur de phase 16 comprend deux portes NON-ET 20 et 21 à deux entrées. La sortie de la porte NON-ET 20 est reliée à une entrée de la porte NON-ET 21 et la sortie de la porte NON-ET 21 est reliée à une entrée de la porte NON-ET 20. La seconde entrée de la porte NON-ET 20 reçoit le signal S₁ et la seconde entrée de la porte NON-ET 21 reçoit le signal S₂. Le signal S₁ est transmis à l'entrée de commande d'une bascule 22 par l'intermédiaire d'un circuit non inverseur 23 présentant un certain retard. La sortie de la porte NON-ET 20 est reliée à l'entrée de données D₁ de la bascule 22. La sortie Q₁ de la bascule 22 commande une bascule 24 montée en compteur, la sortie Q₂ de la bascule 24 étant reliée à son entrée de données D₂ par l'intermédiaire d'un inverseur 25. La sortie Q₂ de la bascule 24 fournit le signal de sélection Φ_{M} qui commande le multiplexeur 15 du dispositif de transformation de fréquence 10.

Les sorties Q₁ et Q₂ des bascules 22 et 24 sont initialement positionnées à "1" et "0" par l'intermédiaire par exemple de signaux d'initialisation (Set, Reset). Tant que les signaux S₁ et S₂ sont décalés de moins d'une demi-période (T/2), la sortie Q₁ de la bascule 22 reste à 1. Au moment où le décalage des signaux S₁ et S₂ dépasse une demi-période, la sortie Q₁ de la bascule 20 passe de 1 à 0. Tant que le décalage des signaux S₁ et S₂ reste compris entre une demi-période (T/2) et une période T, la sortie Q₁ de la bascule 20 reste à 0. Puis quand les signaux S₁ et S₂ sont décalés d'au moins une période T, la sortie Q₁ de la bascule 22 passe de 0 à 1. La sortie Q₂ de la bascule 24 change d'état. Le signal de sélection Φ_{M} changeant d'état, la sélection du multiplexeur 15 s'inverse. Les signaux S₁ et S₂ se décalent à nouveau progressivement et la sortie Q₁ de la bascule 22 passe de nouveau de 1 à 0 et de 0 à 1 et la sélection du multiplexeur s'inverse de nouveau.

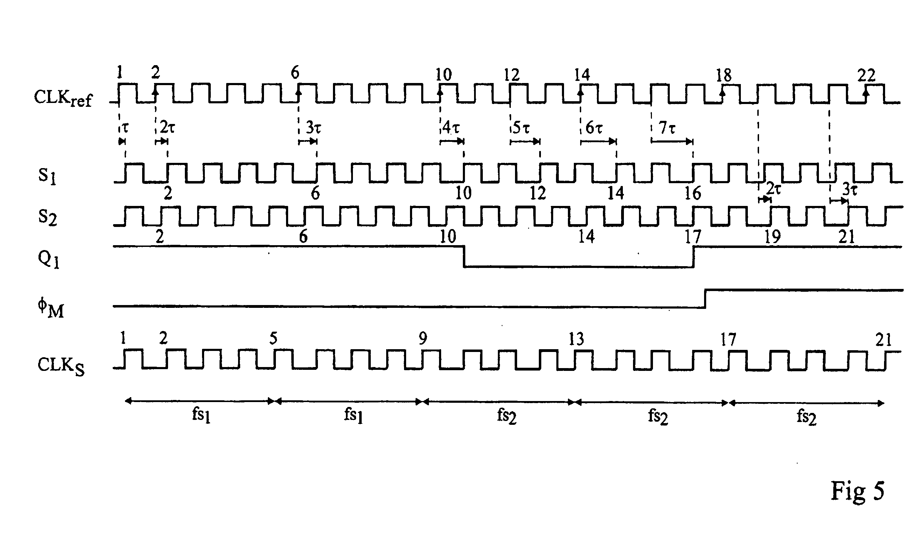

La figure 5 illustre, à titre d'exemple, un autre diagramme possible des signaux du dispositif de transformation 10 de la présente invention. Dans le cas où l'on souhaite obtenir une fréquence fₛ relativement proche de f_{ref} et variable, il devient impossible de réaliser un moyen de retard tel que représenté en figure 4 avec des éléments de retard ayant un temps de propagation très petit, par exemple de l'ordre de 1 fs. Les technologies récentes de fabrication de circuits intégrés permettent en effet de réaliser des éléments de retard ayant un temps de propagation au minimum égal à 10 ps. La présente invention prévoit alors un moyen de fournir un signal d'horloge CLKₛ ayant sur X cycles d'horloge, une fréquence moyenne égale à la fréquence fₛ souhaitée.

Le diagramme de la figure 5 est obtenu avec des moyens de retard composés chacun de six éléments de retard ayant un temps de propagation τ identique et pris égal dans cet exemple à 1/6 de la période de référence T du signal CLK_{ref}. Les 1^{ers} fronts montants représentés des signaux S₁ et CLK_{ref} sont décalés de τ. Le retard DEL1 est ensuite augmenté et vaut alors 2τ. Les 2^{ièmes} fronts montants des signaux S₁ et CLK_{ref} sont ainsi décalés de 2τ. Le retard DEL1 est ensuite inchangé pendant trois cycles du signal CLK_{ref}. Φ_{M} étant nul initialement, le multiplexeur 15 fournit le signal S₁. Le signal d'horloge CLK_{S} a sur ses quatre premiers cycles représentés, une période moyenne égale à 5T/4, ce qui correspond à une fréquence moyenne fₛ₁ de (4/5) *f_{ref}.

Les 6^{ièmes} fronts montants des signaux S₁ et CLK_{ref} sont décalés de 3τ. Le retard DEL1 du moyen de retard 11 est ensuite constant pour les trois cycles suivants du signal CLK_{ref}. La fréquence moyenne du signal d'horloge CLKₛ entre ses 5^{ième} et 9^{ième} fronts montants est identique à la fréquence entre ses 1^{er} et 4^{ième} fronts montants et est égale à fₛ₁.

Les 10^{ièmes} et 11^{ièmes} fronts montants des signaux S₁ et CLK_{ref} sont décalés de 4τ. Puis une nouvelle augmentation du retard DEL1 est effectuée sur le 12^{ième} cycle du signal CLK_{ref}, et les 12^{ièmes} et 13^{ièmes} fronts montants des signaux S₁ et CLK_{ref} sont décalés de 5τ. Dans l'espace de quatre cycles du signal CLKₛ, deux incréments égaux à τ ont été effectués, sa fréquence moyenne fₛ₂ est alors plus faible et vaut (2/3)*f_{ref}.

De façon similaire, un incrément du retard DEL1 est effectué pour les 14^{ième} et 16^{ième} cycles de CLK_{ref}. Les 14^{ièmes} et 15^{ièmes} fronts montants des signaux S₁ et CLK_{ref} sont décalés de 6τ et leurs 16^{ièmes} et 17^{ièmes} fronts montants sont décalés de 7τ . La fréquence moyenne du signal CLKₛ entre ses 13^{ième} et 17^{ième} fronts montants est alors égale à fₛ₂.

Pendant toute cette période, entre le 1^{er} et le 16^{ième} front montant du signal CLKₛ, le signal S₂ suit le signal CLK_{ref} avec un retard DEL2 minimal égal à τ. La sortie Q₁ de la bascule 20 du comparateur de phase 16 est initialement à 1. Puis quand les signaux S₁ et S₂ sont en opposition de phase, c'est-à-dire sur le 10^{ième} front montant du signal S₁, la sortie Q₁ passe à zéro. Au moment où les signaux S₁ et S₂ sont à nouveau en phase, c'est-à-dire sur le 16^{ième} front montant du signal S₁ et le 17^{ième} front montant du signal S₂, la sortie Q₁ passe à un, et le signal de sélection Φ_{M} initialement à "0" passe à "1". Le multiplexeur 15 fournit le signal S₂. Le retard DEL1 est alors rendu minimal et égal à τ, et le retard DEL2 va croître. Les 19^{ièmes} et 20^{ièmes} fronts montants des signaux S₂ et CLK_{ref} sont décalés de 2τ et leurs 21^{ièmes} et 22^{ièmes} fronts montants sont décalés de 3τ. La fréquence fₛ du signal CLKₛ entre ses 17^{ièmes} et 21^{ièmes} fronts montants est donc égale à fₛ₂.

Bien entendu, la présente invention est susceptible de diverses variantes et modifications qui apparaîtront à l'homme de l'art. En particulier, le dispositif de transformation de la présente invention peut être utilisé pour fournir un signal d'horloge CLKₛ ayant une fréquence fₛ plus élevée que la fréquence f_{ref} du signal d'horloge de référence CLK_{ref}. Pour ce faire, les retards DEL1 et DEL2 des moyens de retard 11 et 12 seront initialement maximums. Puis le retard du moyen de retard sélectionné sera progressivement diminué, le retard de l'autre moyen de retard restant maximum. Quand les deux signaux S₁ et S₂ sont à nouveau en phase, la sélection s'inverse.

De plus, l'homme de l'art saura réaliser d'autres moyens de retard et d'autres comparateurs de phase.

## Revendications

1. Dispositif de transformation d'un signal d'entrée périodique (CLK_{ref}) en un signal de sortie (CLKₛ) de fréquence distincte, **caractérisé en ce qu'**il comprend :
- deux moyens de retard réglables (11, 12) recevant le signal d'entrée, la différence entre les retards maximal et minimal de chaque moyen de retard étant supérieure à une période du signal d'entrée ;
- un multiplexeur (15) sélectionnant le signal de sortie (S₁ ou S₂) de l'un ou l'autre des moyens de retard ;
- des moyens de commande (13, 14) pour, selon que la fréquence du signal de sortie doit être inférieure ou supérieure à la fréquence du signal d'entrée, faire croître ou décroître au rythme du signal d'entrée, ou à un multiple de ce rythme, le retard du moyen de retard sélectionné, et commander un retard minimal ou maximal pour le moyen de retard non sélectionné ; et
- un comparateur de phase (16) adapté à changer la sélection du multiplexeur quand les transitions des signaux sortants des moyens de retard (S₁, S₂) correspondant à une même transition du signal d'entrée sont décalées d'une durée supérieure ou égale à une période du signal d'entrée.

2. Dispositif de transformation selon la revendication 1, dans lequel les moyens de commande (13,14) comprennent des moyens pour fixer le rythme d'augmentation ou de diminution du retard du moyen de retard.

3. Dispositif de transformation selon la revendication 1, dans lequel le retard du moyen de retard est susceptible de varier par incréments ou décréments et dans lequel les moyens de commande comprennent des moyens pour fixer la valeur d'incrément ou de décrément.

4. Dispositif de transformation selon la revendication 1, dans lequel chaque moyen de retard comprend plusieurs éléments de retard (D₁ à Dₙ) en série, la sortie de chaque élément de retard étant reliée à la sortie (S) du moyen de retard par l'intermédiaire d'un interrupteur (a₁ à aₙ), l'entrée du premier élément de retard (D₁) étant reliée à l'entrée du moyen de retard (E).

5. Dispositif de transformation selon la revendication 1, dans lequel le comparateur de phase (16) comprend deux portes NON-ET (20, 21) à deux entrées, la sortie d'une porte NON-ET étant reliée à une première entrée de l'autre porte NON-ET, chaque porte NON-ET recevant sur sa seconde entrée un des signaux sortants desdits moyens de retard, un de ces signaux étant transmis à l'entrée de commande d'une première bascule (22) par l'intermédiaire d'un circuit non inverseur (23) présentant un retard, la sortie d'une des portes NON-ET étant reliée à l'entrée de données (D₁) de la première bascule, la sortie de la première bascule (Q₁) commandant une seconde bascule (24) dont la sortie (Q₂) est reliée à son entrée (D₂) par l'intermédiaire d'un inverseur (25), la sortie de la seconde bascule commandant le multiplexeur (15) du dispositif de transformation.

6. Dispositif de transformation selon la revendication 1, dans lequel le retard d'un des moyens de retard augmente ou diminue seulement pendant un ou plusieurs cycles d'un ensemble de cycles du signal d'entrée, le nombre d'augmentations ou de diminutions du retard sur un ensemble de cycles étant d'autant plus élevé que la fréquence du signal de sortie est éloignée de la fréquence du signal d'entrée.

## Claims

1. A device for transforming a periodic input signal (CLK_{ref}) into an output signal (CLKₛ) of distinct frequency, **characterized in that** it comprises:
- two adjustable delay means (11, 12) receiving the input signal, the difference between the maximum and minimum delays of each delay means being greater than one period of the input signal;
- a multiplexer (15) selecting the output signal (S₁ or S₂) of one or the other of the delay means;
- control means (13, 14) for, according to whether the frequency of the output signal must be smaller or greater than the frequency of the input signal, increasing or decreasing at the rate of the input signal, or at a multiple of this rate, the delay of the selected delay means, and controlling a minimum or maximum delay for the delay means which has not been selected, and
- a phase comparator (16) adapted to changing the multiplexer selection when the transitions of the signals output by the delay means (S₁, S₂) corresponding to a same transition of the input signal are offset by a duration greater than or equal to one period of the input signal.

2. The transformation device of claim 1, wherein the control means (13, 14) comprise means for setting the increase or decrease rate of the delay of the delay means.

3. The transformation device of claim 1, wherein the delay of the delay means varies by increments or decrements and the control means comprise means for setting the increment or decrement value.

4. The transformation device of claim 1, wherein each delay means comprises several delay elements (D₁ to Dₙ) in series, the output of each delay element being connected to the output (S) of the delay means via a switch (a₁ to aₙ), the input of the first delay element (D₁) being connected to the input of the delay means (E).

5. The transformation device of claim 1, wherein the phase comparator (16) comprises two NAND gates (20, 21) with two inputs, the output of a NAND gate being connected to a first input of the other NAND gate, each NAND gate receiving on its second input one of the output signals of said delay means, one of these signals being transmitted to the control input of a first flip-flop (22) via a non-inverting circuit (23) exhibiting a delay, the output of one of the NAND gates being connected to the data input (D₁) of the first flip-flop, the output of the first flip-flop (Q₁) controlling a second flip-flop (24), having its output (Q₂) connected to its input via an inverter (25), the output of the second flip-flop controlling the multiplexer (15) of the transformation device.

6. The transformation device of claim 1, wherein the delay of one of the delay means increases or decreases only during one or several cycles of a set of cycles of the input signal, the number of increases or decreases of the delay over a set of cycles being all the greater as the frequency of the output signal is remote from the frequency of the input signal.

## Patentansprüche

1. Vorrichtung zum Transformieren eines periodischen Eingangssignals (CLK_{ref}) in ein Ausgangssignal (CLKₛ) mit ausgeprägter Frequenz, **gekennzeichnet durch** folgende Merkmale:
zwei einstellbare Verzögerungseinrichtungen (11, 12), welche das Eingangssignal empfangen, wobei die Differenz zwischen der maximalen und der minimalen Verzögerung jeder Verzögerungseinrichtung größer ist als eine Periode des Eingangssignals;
ein Multiplexer (15), welcher das Ausgangssignal (S₁ oder S₂) der einen oder der anderen Verzögerungseinrichtung auswählt;
eine Steuereinrichtung (13, 14), welche abhängig davon, ob die Frequenz des Ausgangssignals kleiner oder größer sein soll als die Frequenz des Eingangssignals, in bezug auf die Rate des Eingangssignals oder auf ein Vielfaches dieser Rate die Verzögerung der ausgewählten Verzögerungseinrichtung erhöht oder senkt und eine minimale oder maximale Verzögerung für die Verzögerungseinrichtung, die nicht ausgebildet wurde, steuert, und
ein Phasenvergleicher (16), welcher die Multiplexerauswahl ändern kann, wenn die Übergänge der Signale, welche von den Signaleinrichtungen (S₁, S₂) ausgegeben werden, die einem gleichen Übergang des Eingangssignals entsprechen, um eine Dauer versetzt sind, die größer oder gleich einer Periode des Eingangssignals ist

2. Transformationseinrichtung nach Anspruch 1, wobei die Steuereinrichtung (13, 14) Mittel zum Einstellen der Erhöhungs- oder Senkungsrate der Verzögerung der Verzögerungseinrichtung umfaßt.

3. Transformationseinrichtung nach Anspruch 1, wobei die Verzögerung der Verzögerungseinrichtung in Inkrementen oder Dekrementen variiert und die Steuereinrichtung Mittel zum Einstellen des Wertes der Inkremente oder Dekremente umfaßt.

4. Transformationseinrichtung nach Anspruch 1, wobei jede Verzögerungseinrichtung mehrere Verzögerungselemente (D₁ bis Dₙ) in Reihe umfaßt, wobei der Ausgang jedes Verzögerungselementes mit dem Ausgang (S) der Verzögerungseinrichtung über einen Schalter (a₁ bis aₙ) verbunden ist und der Eingang des ersten Verzögerungselementes (D₁) mit dem Eingang der Verzögerungseinrichtung (E) verbunden ist.

5. Transformationseinrichtung nach Anspruch 1, wobei der Phasenvergleicher (16) zwei NAND-Gatter (20, 21) mit zwei Eingängen umfaßt, wobei der Ausgang eines NAND-Gatters mit einem ersten Eingang des anderen NAND-Gatters verbunden ist, jedes NAND-Gatter an seinem zweiten Eingang eines der Ausgangssignale der Verzögerungseinrichtungen empfängt, eines dieser Signale an den Steuereingang eines ersten Flip-Flops (22) über einen nicht-invertierenden Schaltkreis (23), der eine Verzögerung aufweist, gesandt wird, der Ausgang eines der NAND-Gatter mit dem Dateneingang (D₁) des ersten Flip-Flops verbunden ist, der Ausgang des ersten Flip-Flops (Q₁) ein zweites Flip-Flop (24) steuert, dessen Ausgang (Q₂) mit seinem Eingang über einen invertierer (25) verbunden ist, und wobei der Ausgang des zweiten Flip-Flops den Multiplexer (15) der Transformationseinrichtung steuert.

6. Transformationseinrichtung nach Anspruch 1, wobei die Verzögerung einer der Verzögerungseinrichtungen nur während eines oder mehrerer Zyklen einer Gruppe von Zyklen des Eingangssignals erhöht oder gesenkt wird, wobei die Anzahl der Erhöhungen oder Senkungen der Verzögerung während einer Gruppe von Zyklen um so größer ist, je weiter die Frequenz des Ausgangssignals von der Frequenz des Eingangssignals entfernt ist
